(19) Europäisches Patentamt
European Patent Office
Office européen des brevets

(11) **EP 1 105 716 B1**

(12) **EUROPEAN PATENT SPECIFICATION**

(45) Date of publication and mention
of the grant of the patent:
**26.10.2005 Bulletin 2005/43**

(51) Int Cl.⁷: $G01N\ 21/88$, G01R 31/309,
G06T 7/00

(21) Application number: **98939825.0**

(22) Date of filing: **18.08.1998**

(86) International application number:
**PCT/IL1998/000393**

(87) International publication number:
**WO 2000/011454 (02.03.2000 Gazette 2000/09)**

(54) **INSPECTION OF PRINTED CIRCUIT BOARDS USING COLOR**

INSPEKTION VON LEITERPLATTEN UNTER VERWENDUNG VON FARBE

CONTROLE PAR COULEUR DE PLAQUETTES DE CIRCUITS IMPRIMES

(84) Designated Contracting States:
**DE FI FR GB IE NL SE**

(43) Date of publication of application:
**13.06.2001 Bulletin 2001/24**

(73) Proprietor: **ORBOTECH LTD.**
**Yavne 81102 (IL)**

(72) Inventors:
• **KAMINSKY, Ronald, F.**
**44351 Kfar Saba (IL)**
• **GROBGELD, Peter**
**76285 Rehovot (IL)**

• **SPECTOR, Yuval**
**76352 Rehovot (IL)**
• **LIPMAN, Eliezer**
**75321 Rishon Lezion (IL)**

(74) Representative: **van Westenbrugge, Andries et al**
**Nederlandsch Octrooibureau**
**P.O. Box 29720**
**2502 LS The Hague (NL)**

(56) References cited:
**EP-A- 0 160 781       EP-A- 0 426 182**
**EP-A- 0 594 146**

**Description**

FIELD OF THE INVENTION

The present invention is related to the field of inspection of patterned surfaces, such as printed circuit boards and in particular to the identification of certain types of conditions, such as conductor oxidation, using color.

BACKGROUND OF THE INVENTION

One widely used method for inspection of "bare" printed circuit boards having metalized portions and, unmetalized, laminate portions is to:

(a) illuminate the board with light which appears to come from a wide range of angular directions;
(b) image the illuminated portion;
(c) define the metalized portions from the image of the board; and
(d) determine defects in metalization on the board by one or more of comparison of the image with a standard image and analysis of the image with a set of standards or rules to determine if it meets the rules.

Among prior art publications which describe such methods are US Patents 4,758,888; 5,619,429; 5,774,572; and 5,774,573.

One of the problems in making this comparison is the determination of edges between areas covered by conductors on the board and areas without conductors. A number of publications, including, for example, US Patent 5,524,152, have suggested the use of color to improve this determination. In general, these methods image the board utilizing a color at which the contrast between the conductors and areas from which the conductors have been removed is maximized. This may be achieved by illuminating the surface with light which maximizes contrast or by filtering the light which is reflected prior to forming the image. In particular, the above referenced US Patent 5,524,152 generates one or more different images each based on a different filter to emphasize different materials, such as gold copper, etc.

US Patent 5,483,603, defines a region in RGB space that characterizes a conductor and a region in RGB space that characterizes a laminate. Pixels are classified as conductors or laminate depending on which regions contains their RGB values.

While ideally, the board should consist of only two types of areas, namely metal and bare substrate, unfortunately the metalization on a board is sometimes oxidized. Furthermore, several types of oxidation and various levels of severity of oxidation exist, making it difficult to determine criteria for reliably identifying oxidation.

Since oxidation is a widespread phenomena in printed circuit board manufacture, especially when the boards have been in storage for a considerable period of time and/or have been stored under less than ideal conditions, it would be useful to be able to reliably determine areas of oxidation on printed circuit boards. Such identification could be useful, for example, in avoiding classification of such areas as containing defects.

SUMMARY OF THE INVENTION

In a broad aspect of the invention, the present invention determines the presence of oxide on a conductor on a printed circuit board from an image of the printed circuit board.

In accordance with some preferred embodiments of the invention, color characteristics of light reflected from the surface of a printed circuit board are used to determine if the area is an oxidized conductor. The method of the present invention may be used in any imaging system in which images at multiple colors are acquired.

According to one broad aspect of the present invention, the presence of an oxide (or another definable aspect of the pixel) is determined by comparing the color characteristics of a suspect pixel with the color characteristics of either the metalization or laminate portions, preferably, the metal portions.

According to a second broad aspect of the present invention, the presence of an oxide (or another definable aspect of the image) is determined by comparing the color components of a suspect pixel utilizing a normalizing scale based on the color characteristics of either the metalization or laminate portions, preferably, the metal portions.

According to a third broad aspect of the present invention, the presence of an oxide is determined by first finding a region of the color space which is characteristic of oxide and then determining if the color values of a pixel is within this region.

In accordance with one aspect of some preferred embodiments of the invention, the determination of an oxide is made without directly excluding the presence of a laminate. In addition, in some preferred embodiments of the invention, only "interior" pixels (that is pixels not near an edge) are classified as oxide.

In a preferred embodiment of the invention each of the color scales for RGB is first normalized between a low light level and the reflection from fine (unoxidized) copper. Preferably, the "dark level" is set at a few gray levels above zero and the "copper level" is set at a few gray levels below the maximum gray level. For example, the darkest portion of the image may be set at 10 gray levels and the copper (brightest) gray level set at 230 gray levels for 8 bit quantification of light level.

In a preferred embodiment of the invention, a pixel having a red intensity below a red threshold level is determined not to be an oxide. For other pixels, for which not all of the colors have intensities within a range indicative of copper, preferably the red level is compared to the level of other colors. If the red (normalized) level is greater than both the green (normalized) and blue (normalized) levels, the pixel is identified as brown oxide, the most prevalent type. Different combinations of characteristics may be used for determining the presence of other oxide types.

In other preferred embodiments of the invention, a comparison is made with brightness levels of the laminate.

Similar comparisons are useful for determining other types of oxidation and/or laminate problems and may be useful for the determination of the presence of other materials such as gold, tin-lead, or double treated copper conductors, cyanide ester, polymid or teflon laminate, photoresist residues or dust.

There is thus provided, a method of analysis of a printed circuit board comprising:

generating an image of the printed circuit board; and
determining the presence of an oxide from an analysis of the image.

Preferably, determination of the presence of an oxide is made without determining whether the pixel is a laminate pixeL

Preferably, generating an image comprises generating a pixelated image having brightness values for each pixel and determining the presence of the of an oxide comprises determining the presence of the oxide responsive to the brightness values.

Preferably, generating an image comprises generating a plurality of images each at a different color and having brightness values for each pixel in each image and determining the presence of an oxide includes making the determination based on an analysis of the pixel values in at least two of the images. Preferably, the plurality of images comprises a red, a green and a blue image.

Preferably, determination of the presence of an oxide includes eliminating pixels from consideration based on a brightness value for a single color. Preferably the color is red and pixels having a red brightness level below a given value are eliminated from consideration as being an oxide. Preferably, the color is red and wherein pixels having a red value above a given value are eliminated from consideration as being an oxide.

In a preferred embodiment of the invention, determination of the presence of an oxide includes eliminating pixels from consideration based on a comparison between the brightness level of two colors. Preferably, the two colors are red and green and wherein the pixel is eliminated if its red brightness value compared to that of copper is less than its green brightness value compared to copper. Preferably, the two colors are red and blue and wherein the pixel is eliminated if its red brightness value compared to that of copper is less than its blue brightness value compared to copper.

In a preferred embodiment of the invention, determination of the presence of an oxide includes eliminating pixels from consideration based on an analysis of the brightness levels of three colors.

In a preferred embodiment of the invention, determination of the presence of an oxide includes eliminating pixels from consideration based on a comparison between the brightness level of three colors with brightness levels for copper. Preferably, a pixel is eliminated from consideration as an oxide when its color brightness values have a Mahalanobis distance greater than a given value from the mean values of the brightness values for copper. Preferably, the given value for the Mahalanobis distance is between 4 and 8, more preferably, about 6.

In a preferred embodiment of the invention, the determination of the presence of an oxide is made based on a relationship between the brightness values of the image and brightness values characteristic of copper.

Preferably, the method includes:

determining a color gamut characteristic of the oxide; and
comparing the color values of a pixel to the determined gamut of values to determine if the pixel is an oxide.

The invention will be more clearly understood from the following description of non-limiting preferred embodiments thereof.

DESCRIPTTON OF PREFERRED EMBODIMENTS OF THE INVENTION

In a preferred embodiment of the invention, a printed circuit board (PCB) is illuminated by multi-wavelength light and imaged in a plurality of colors, for example in RGB. While the methods of the invention are applicable to any imaging system in which images at multiple colors are acquired, in an especially preferred embodiment of the invention, the PCB is illuminated by and the images are acquired by the apparatus described in PCT patent application PCT/IL98/00285, filed June 15, 1998.

In a preferred embodiment of the invention in which it is desired to determine the presence of brown oxide, three color images, namely R, G and B images are generated. Optionally, as disclosed in PCT/IL98/00285, filters are used to reduce any cross-over of colors between the images, such that each image represents reflections in a different wavelength. Alternatively, white light is used for illumination and standard light division (and associated overlapping sensitivity) is used.

As a first preferred step in the determination, a set-up is performed to calibrate the system. This calibration is preferably performed utilizing a standard manufactured, bare, PCB, preferably fee of oxide. Preferably, an operator chooses a portion of the board which has a mix of interior copper pixels, edge pixels and some laminate pixels.

First, the brightness of the illumination and the camera and A/D parameters are adjusted such that the gray level for each of the colors RGB for subsequently acquired images will have a dark level of about 10 and a value for a copper pixel of about 230 for 8 bit quantification of light level.

The next step is to define a "low sure" threshold from an analysis of transition pixels (pixels on or near transitions between conductor and laminate). This calculation is in accordance with the calculation detailed in Fig. 15 from US Patent 5,774,573 (Caspi et al.) except that only the gray level value is accumulated, not ordered pairs of (gray level, gray level difference). The object of this threshold is to define pixels whose red level is so low that they cannot be an oxide. Other thresholds and methods of defining such thresholds may be used instead of the "low-sure" threshold.

The next step in the set-up is to produce a 3-D histogram of the colors of all the interior copper pixels in the region of limited size. It has been found that a region of 700 by 700 pixels gives adequate statistics. For the 3-D histogram, the mean is computed. The mean may also be computed from the three separate color distributions.

Preferably, a covariance matrix is formed from the values. This matrix is:

$$\sum \frac{(R_i - \bar{R})^2}{(N-1)} \qquad \sum \frac{(R_i - \bar{R}) \cdot (G_i - \bar{G})}{(N-1)} \qquad \sum \frac{(R_i - \bar{R}) \cdot (B_i - \bar{B})}{(N-1)}$$

$$\sum \frac{(R_i - \bar{R}) \cdot (G_i - \bar{G})}{(N-1)} \qquad \sum \frac{(G_i - \bar{G})^2}{(N-1)} \qquad \sum \frac{(G_i - \bar{G}) \cdot (B_i - \bar{B})}{(N-1)}$$

$$\sum \frac{(R_i - \bar{R}) \cdot (B_i - \bar{B})}{(N-1)} \qquad \sum \frac{(G_i - \bar{G}) \cdot (B_i - \bar{B})}{(N-1)} \qquad \sum \frac{(B_i - \bar{B})^2}{(N-1)}$$

This matrix is inverted to form an inverted covariance matrix. This inverted matrix is used to determine if a pixel is an oxide.

In a preferred embodiment of the invention, the following rules are applied to image pixels in a PC board under test to determine if a pixel is oxidized.

1) if the pixel is at a strong gradient (for example, it is an edge pixel), it is not checked and is not marked as an oxide;
2) if is Mahalanobis distance (as defined below) from the mean value of copper pixels is less than some given value, it is not an oxide; This value may vary between about 4 and 8, with 6 being a preferred value;
3) if the red pixel value is less than the low-sure threshold for red, it is not classified as an oxide (it is definitely laminate);
4) optionally, if red is less than green for a pixel, it is not classified as an oxide;
5) optionally, if red is less than blue for a pixel, it is not classified as an oxide; and
6) optionally, if the red value is greater than some high value (for example, 220) it is not classified as an oxide.

The Mahalanobis distance for a pixel is determined by forming a vector and pre-multiplying the inverted covariance matrix by the vector and then post-multiplying the product by the transpose of the vector. The scalar that results from this "modified inner product" of the vector is the square of the Mahalanobis distance.

A preferred algorithm for determining if a pixel is at a strong gradient (i.e., it is considered to be an edge pixel and thus not subject to the above analysis) is:

Let I[x,y] be the gray level value of the red image at location (x,y).

To calculate if the pixel at location (x,y) is an edge pixel:

Let s = ceo(I[x-2,y],I[x-1,y],I[x,y],I[x+1,y],I[x+2,y])

+ ceo(I[x,y-2],I[x,y-1],I[x,y],I[x,y+1],I[x,y+2])
+ ced(I[x-2,y-2],I[x-1,y-1],I[x,y],I[x+1,y+1],I[x+2,y+2])
+ ced(I[x-2,y+2],I[x-1,y+1],I[x,y],I[x+1,y-1],I[x+2,y-2])

where the functions ceo() and ced() are defined by the computer program fragment below.
Then if s >= 12, the pixel at (x,y) is an edge pixel.

```
> typedef unsigned char uchar;
>
> static int sst[4][4] = { {1, 2, 2, 2}, {2,-1, 2, 2},
>                          {2, 2, 0, 0}, {2, 2, 0, 0}};
>
> int f(int d)
> {
>   return (abs(d) < 4 ? 0 : (abs(d) < 8 ? 1 :
>   (abs(d) < 12 ? 2 : (abs(d) < 16 ? 3 :
>   (abs(d) < 24 ? 4 : (abs(d) < 36 ? 5 :
>   (abs(d) < 128 ? 6 : 7))))))) * (d < 0 ? -1 : 1);
> }
>
> void ht(float d1, float d2, int *s, float *v)
> {
>   *v = 0.375*d1 + 0.125*d2 ;
>
>   if ( fabs(*v) < 0.3 )
>       *s = (fabs(d1) < 0.1) ? 2 : 3 ;
>   else {
>       *s = (*v>0) ? 0 : 1 ;
>   }
>   *v = fabs(*v);
> }
>
> int ct(int d[4])
> {
>   int s, s1, s2;
>   float v1, v2, ret;
>   int t, v;
```

```
>
>    ht(-d[1], -d[0], &s1, &v1);
>    ht(d[2], d[3], &s2, &v2);
>
>    ret = (v1+v2+1)/2 ;
>    if (ret > 3)
>        ret = 3;
>    if (ret < -3)
>        ret = -3;
>    v = (int) ret ;
>
>    s = sst[s1][s2];
>
>    if (s == 2) {
>        if (fabs(v1) > 2 || fabs(v2) > 2)
>            t = 4;
>        else
>            t = 0;
>    }
>    else
>        t = 0;
>
>    return t;
> }
>
> int ceo(uchar g0, uchar g1, uchar g2, uchar g3, uchar g4)
> {
>    int d[4];
>
>    d[0] = f(g1-g0);
>    d[1] = f(g2-g1);
>    d[2] = f(g3-g2);
>    d[3] = f(g4-g3);
>    return ct(d);
> }
>
> int ced(uchar g0, uchar g1, uchar g2, uchar g3, uchar g4)
> {
>    int d[4];
>
>    d[0] = f((g1-g0)/sqrt(2));
>    d[1] = f((g2-g1)/sqrt(2));
>    d[2] = f((g3-g2)/sqrt(2));
>    d[3] = f((g4-g3)/sqrt(2));
>    return ct(d);
> }
```

In an alternate preferred embodiment of the invention, a multi-dimensional region of color space characteristic of an oxide, whose presence is to be tested, is determined. Such a determination may be made by imaging a number of samples of oxide and determining the range, in color space, of the images. During testing, the color values of teat pixels are compared to the values in the determined region. If the values are within the region, the pixel is labeled as an oxide. Optionally, edge and other high gradient pixels are excluded from classification as oxides. While such color maps have been used, in the past, to determine metal and laminate, they have not been used to determine the presence of oxide and have not been used in conjunction with gradient information.

One preferred use of the information determined by the above described method is in avoiding the classification oxide pixels as faults in a printed circuit board. Since these pixels generally have a brightness between that of copper and laminate, they may sometimes be classified as laminate by normal threshold programs. Edge finding programs may also have difficulty in determining edges near oxide. Thus, when the above method determines that a pixel is oxide, it is, for the purposes of a fault determination program, defined as a metal pixel.

## Claims

1. A method of analysis of a printed circuit board comprising:

    generating an image of the printed circuit board; **characterized by**:

        determining the presence of an oxide from an analysis of the image.

2. A method according to claim 1 wherein determination of the presence of an oxide is made without determining whether the pixel is a laminate pixel.

3. A method according to claim 1 or claim 2 wherein generating an image comprises generating a pixelated image having brightness values for each pixel and wherein determining the presence of an oxide comprises determining the presence of the oxide responsive to the brightness values.

4. A method according to claim 1 or claim 2 wherein generating an image comprises generating a plurality of images each at a different color and having brightness values for each pixel in each image and wherein determining the presence of an oxide includes making the determination based on an analysis of the pixel values in at least two of the images.

5. A method according to claim 4 wherein the plurality of images comprises a red, a green and a blue image.

6. A method according to claim 4 or claim 5 wherein determination of the presence of an oxide includes eliminating pixels from consideration based on a brightness value for a single color.

7. A method according to claim 6 wherein the color is red and wherein pixels having a red brightness level below a given value are eliminated from consideration as being an oxide.

8. A method according to claim 6 or claim 7 wherein the color is red and wherein pixels having a red value above a given value are eliminated from consideration as being an oxide.

## Patentansprüche

1. Verfahren zur Analyse einer Leiterplatte, umfassend: das Erzeugen der Abbildung einer Leiterplatte, **gekennzeichnet durch**
   das Bestimmen der Anwesenheit eines Oxids **durch** eine Analyse der Abbildung.

2. Verfahren nach Anspruch 1, wobei das Bestimmen der Anwesenheit eines Oxids erfolgt, ohne zu bestimmen, ob das Pixel ein Pixel des Laminates ist.

3. Verfahren nach Anspruch 1 oder 2, wobei das Erzeugen einer Abbildung das Erzeugen einer gepixelten Abbildung umfasst, welche Helligkeitswerte für jedes Pixel aufweist, und wobei das Bestimmen der Anwesenheit eines Oxids das Bestimmen der Anwesenheit des Oxids umfasst, das auf die Helligkeitswerte reagiert.

4. Verfahren nach Anspruch 1 oder 2, wobei das Erzeugen einer Abbildung das Erzeugen von mehreren Abbildungen umfasst, jede in einer anderen Farbe und wobei in jeder Abbildung jedes Pixel Helligkeitswerte aufweist und wobei das Bestimmen der Anwesenheit eines Oxids das Durchführen der Bestimmung auf der Grundlage einer Analyse der Pixelwerte in mindestens zwei der Abbildungen umfasst.

5. Verfahren nach Anspruch 4, wobei die mehreren Abbildungen eine rote, eine grüne und eine blaue Abbildung umfassen.

6. Verfahren nach Anspruch 4 oder 5, wobei das Bestimmen der Anwesenheit eines Oxids das Außerachtlassen von Pixeln auf der Grundlage eines Helligkeitswertes für eine einzelne Farbe umfasst.

7. Verfahren nach Anspruch 6, wobei die Farbe Rot ist und wobei Pixel mit einem roten Helligkeitswert unterhalb eines bestimmten Wertes nicht als Oxid gelten.

8. Verfahren nach Anspruch 6 oder 7, wobei die Farbe Rot ist und wobei Pixel mit einem Rotwert über einem bestimmten Wert nicht als Oxid gelten.

## Revendications

1. Procédé d'analyse d'une carte de circuit imprimé comprenant :

la génération d'une image de la carte de circuit imprimé ; **caractérisé par** :

la détermination de la présence d'un oxyde à partir de l'analyse de l'image.

2. Procédé selon la revendication 1 dans lequel la détermination de la présence d'un oxyde est effectuée sans déterminer si le pixel est un pixel du stratifié.

3. Procédé selon la revendication 1 ou la revendication 2 dans lequel la génération d'une image comprend la génération d'une image pixélisée présentant des valeurs de luminosité pour chaque pixel et dans lequel la détermination de la présence d'un oxyde comprend la détermination de la présence de l'oxyde en réponse aux valeurs de luminosité.

4. Procédé selon la revendication 1 ou la revendication 2, dans lequel la génération d'une image comprend la génération d'une pluralité d'images chacune à une couleur différente et présentant des valeurs de luminosité pour chaque pixel dans chaque image et dans lequel la détermination de la présence d'un oxyde comprend la réalisation de la détermination fondée sur une analyse des valeurs de pixel dans au moins deux des images.

5. Procédé selon la revendication 4 dans lequel la pluralité d'images comporte une image rouge, une image verte et une image bleue.

6. Procédé selon la revendication 4 ou la revendication 5 dans lequel la détermination de la présence d'un oxyde comprend l'élimination des pixels de l'examen fondée sur une valeur de luminosité pour une seule couleur.

7. Procédé selon la revendication 6 dans lequel la couleur est rouge et dans lequel les pixels présentant un niveau de luminosité rouge en dessous d'une valeur donnée sont éliminés de l'examen comme étant un oxyde.

8. Procédé selon la revendication 6 ou la revendication 7 dans lequel la couleur est rouge et dans lequel les pixels présentant une valeur de rouge au-dessus d'une valeur donnée sont éliminés de l'examen comme étant un oxyde.